# EUROPEAN PATENT APPLICATION

(11) **EP 3 428 837 A1**
(43) Date of publication of application: **16.01.2019**
(21) Application number: 17904357.5
(22) Date of filing: 12.04.2017
(51) Int. Cl.: G06K 9/00, H01L 23/10, H01L 21/50

(54) **OPTICAL FINGERPRINT SENSOR AND PACKAGING METHOD THEREFOR**

(71) Applicant: Shenzhen Goodix Technology Co., Ltd., Shenzhen, Guangdong 518045 (CN)
(72) Inventor: LONG, Wei, Shenzhen Guangdong 518045 (CN); WU, Baoquan, Shenzhen Guangdong 518045 (CN)
(74) Representative: AWA Denmark A/S
(86) International application number: PCT/CN2017/080229
(87) International publication number: WO 2018/187963

(57) **Abstract**

An optical fingerprint sensor and a packaging method of an optical fingerprint sensor, where the optical fingerprint sensor includes a package substrate (107), a sensor chip (104), an optical cover (101) and a connection unit (106), and the optical cover (101) is light-transmissive. A lower surface of the sensor chip (104) is adhered to an upper surface of the package substrate (107) by a first adhesive layer (105), and a lower surface of the optical cover (101) is adhered to an upper surface of the sensor chip (104) by a second adhesive layer (102), the sensor ship (104) is connected to the package substrate (107) by the connection unit (106), plastic package is performed on sides of the package substrate (107), the first adhesive layer (105), the sensor chip (104), the second adhesive layer (102) and the optical cover (101) by a plastic package colloid (103), and the second adhesive layer (102) is light-transmissive. According to the optical fingerprint sensor and the packaging method of the optical fingerprint sensor, a volume of the optical fingerprint sensor can be reduced so that the optical fingerprint sensor can be better hidden in an electronic device.

## Description

### TECHNICAL FIELD

The present disclosure relates to the field of electronic devices, and in particular, to an optical fingerprint sensor and a packaging method of an optical fingerprint sensor.

### BACKGROUND

With increasingly diverse demands for appearance of a fingerprint sensor by customers, the customers are not satisfied with a structure of a current through-hole fingerprint sensor, because the through-hole fingerprint sensor will change an appearance structure of a terminal. Although a blind-hole fingerprint sensor protects the appearance well, a poor yield and other issues caused by drilling a blind hole are also major problems.

Although a penetration thickness of the optical fingerprint sensor can be more than 700 µm, a package thickness of a conventional optical fingerprint sensor is too thick to meet requirements of a smaller size for a fingerprint sensor.

### SUMMARY

The present disclosure provides an optical fingerprint sensor and a packaging method of an optical fingerprint sensor, which can reduce a volume of the optical fingerprint sensor so that the optical fingerprint sensor can be better hidden in an electronic device.

According to a first aspect, the present disclosure provides an optical fingerprint sensor, where the optical fingerprint sensor includes a package substrate, a sensor chip, an optical cover, a plastic package colloid and a connection unit, and the optical cover is light-transmissive; a lower surface of the sensor chip is adhered to an upper surface of the package substrate by a first adhesive layer, and a lower surface of the optical cover is adhered to an upper surface of the sensor chip by a second adhesive layer, the sensor ship is connected to the package substrate by the connection unit, plastic package is performed on sides of the package substrate, the first adhesive layer, the sensor chip, the second adhesive layer and the optical cover by the plastic package colloid, and the second adhesive layer is light-transmissive.

According to the optical fingerprint sensor in an embodiment of the present disclosure, since the optical cover and the sensor chip are adhered together by the second adhesive layer, seamlessly and directly attachment of the optical cover and the sensor chip can be achieved, and a volume of the entire optical fingerprint sensor can be reduced, so that availability of the optical fingerprint sensor in an electronic device can be improved.

In addition, the use of the plastic package colloid to perform the plastic package on the package substrate, the first adhesive layer, the sensor chip, the second adhesive layer and the optical cover can provide a protective effect.

It should be noted that the plastic package colloid shall expose an upper surface of the optical cover.

In a possible implementation, the plastic package colloid is opaque to light. This can improve the performance of the optical fingerprint sensor.

In a possible implementation, a height difference of an upper surface of the optical cover and an upper surface of the plastic package colloid is greater than or equal to 0 and less than or equal to 50 microns. This can improve the performance of the optical fingerprint sensor.

In a possible implementation, a side of the optical cover has a screw thread or a lock type structure.

In a possible implementation, at least one of the package substrate, the first adhesive layer, and the lower surface of the sensor chip is opaque to light.

In a possible implementation, the lower surface of the optical cover completely covers a pixel area of the sensor chip. In other words, a size of the optical cover is larger than a size of the pixel area of the sensor chip. This can improve the performance of the optical fingerprint sensor.

In a possible implementation, the optical cover is a silicon dioxide layer formed by means of spin-coating, or a glass sheet or a resin sheet produced by means of lamination processing.

According to a second aspect, the present disclosure provides a packaging method of an optical fingerprint sensor, where the optical fingerprint sensor includes a package substrate, a sensor chip, an optical cover, a plastic package colloid and a connection unit, the optical cover is light-transmissive, and the packaging method includes: adhering a lower surface of the sensor chip and an upper surface of the package substrate using a first adhesive layer; connecting the sensor chip and the package substrate using the connection unit; adhering a lower surface of the optical cover and an upper surface of the sensor chip using a second adhesive layer, where the second adhesive layer is light-transmissive; and performing plastic package on sides of the package substrate, the first adhesive layer, the sensor chip, the second adhesive layer and the optical cover using the plastic package colloid.

According to the optical fingerprint sensor packaged by using the packaging method in an embodiment of the present disclosure, since the optical cover and the sensor chip are adhered together by the second adhesive layer, seamlessly and directly attachment of the optical cover and the sensor chip can be achieved, and a volume of the entire optical fingerprint sensor can be reduced, so that availability of the optical fingerprint sensor in an electronic device can be improved.

In addition, the use of the plastic package colloid to perform the plastic package on the package substrate, the first adhesive layer, the sensor chip, the second adhesive layer and the optical cover can provide a protective effect.

It should be noted that the plastic package colloid shall expose an upper surface of the optical cover.

In a possible implementation, the plastic package colloid is opaque to light. This can improve the performance of the optical fingerprint sensor.

In a possible implementation, a height difference of an upper surface of the optical cover and an upper surface of the plastic package colloid is greater than or equal to 0 and less than or equal to 50 microns. This can improve the performance of the optical fingerprint sensor.

In a possible implementation, a side of the optical cover has a screw thread or a lock type structure.

In a possible implementation, the lower surface of the optical cover completely covers a pixel area of the sensor chip. This can improve the performance of the optical fingerprint sensor.

In a possible implementation, the optical cover is a silicon dioxide layer formed by means of spin-coating, or a glass sheet or a resin sheet produced by means of lamination processing.

According to a third aspect, the present disclosure provides an optical fingerprint sensor. The optical fingerprint sensor includes a package substrate, a sensor chip, a plastic package colloid and a connection unit, and the optical cover is light-transmissive; a lower surface of the sensor chip is adhered to an upper surface of the package substrate by a first adhesive layer, the sensor ship is connected to the package substrate by the connection unit, plastic package is performed on sides of the package substrate, the first adhesive layer and the sensor chip by the plastic package colloid, and an upper surface of the plastic package colloid is higher than an upper surface of the sensor chip.

According to the optical fingerprint sensor in an embodiment of the present disclosure, the optical cover and the sensor chip are adhered together by a second adhesive layer, and therefore seamlessly and directly attachment of the optical cover and the sensor chip can be achieved, and a volume of the optical fingerprint sensor after installing the optical cover can be reduced, so that availability of the optical fingerprint sensor in an electronic device can be improved.

In addition, the use of the plastic package colloid to perform the plastic package on the package substrate, the first adhesive layer and the sensor chip can provide a protective effect.

It should be noted that the plastic package colloid shall expose the pixel area of the sensor chip.

In a possible implementation, the plastic package colloid is opaque to light. This can improve the performance of the optical fingerprint sensor.

In a possible implementation, at least one of the package substrate, the first adhesive layer, and the lower surface of the sensor chip is opaque to light. This can improve the performance of the optical fingerprint sensor.

According to a fourth aspect, the present disclosure provides a packaging method of an optical fingerprint sensor, where the optical fingerprint sensor includes a package substrate, a sensor chip, a plastic package colloid and a connection unit, and the packaging method includes: adhering a lower surface of the sensor chip and an upper surface of the package substrate using a first adhesive layer; connecting the sensor chip and the package substrate using the connection unit; and performing plastic package on sides of the package substrate, the first adhesive layer and the sensor chip using the plastic package colloid, where an upper surface of the plastic package colloid is higher than an upper surface of the sensor chip.

According to the optical fingerprint sensor packaged by using the packaging method in an embodiment of the present disclosure, the optical cover and the sensor chip are adhered together by the second adhesive layer, and therefore seamlessly and directly attachment of the optical cover and the sensor chip can be achieved, and a volume of the optical fingerprint sensor after installing the optical cover can be reduced, so that availability of the optical fingerprint sensor in an electronic device can be improved.

In addition, the use of the plastic package colloid to perform the plastic package on the package substrate, the first adhesive layer and the sensor chip can provide a protective effect.

It should be noted that the plastic package colloid shall expose the pixel area of the sensor chip.

In a possible implementation, the plastic package colloid is opaque to light.

In a possible implementation, at least one of the package substrate, the first adhesive layer, and the lower surface of the sensor chip is opaque to light.

According to a fifth aspect, the present disclosure provides a packaging method of an optical fingerprint sensor, where the optical fingerprint sensor is the optical fingerprint sensor according to the third aspect or any one of the possible implementations, and the packaging method includes: adhering a lower surface of an optical cover to the upper surface of the sensor chip of the optical fingerprint sensor using a second adhesive layer.

According to the optical fingerprint sensor packaged by using the packaging method in an embodiment of the present disclosure, the optical cover and the sensor chip are adhered together by the second adhesive layer, and therefore seamlessly and directly attachment of the optical cover and the sensor chip can be achieved, and a volume of the optical fingerprint sensor after installing the optical cover can be reduced, so that availability of the optical fingerprint sensor in an electronic device can be improved.

In a possible implementation, a height difference of an upper surface of the optical cover and the upper surface of the plastic package colloid of the optical fingerprint sensor is greater than or equal to 0 and less than or equal to 50 microns.

### BRIEF DESCRIPTION OF DRAWINGS

FIG. 1 is an exemplary structural diagram of an optical fingerprint sensor according to an embodiment of the present disclosure;
FIG. 2 is a schematic flow diagram of a packaging method of an optical fingerprint sensor according to an embodiment of the present disclosure;
FIG. 3 is an exemplary structural diagram of an optical fingerprint sensor according to another embodiment of the present disclosure;
FIG. 4 is a schematic flow diagram of a packaging method of an optical fingerprint sensor according to another embodiment of the present disclosure; and
FIG. 5 is a schematic flow diagram of a packaging method of an optical fingerprint sensor according to yet another embodiment of the present disclosure.

### DESCRIPTION OF EMBODIMENTS

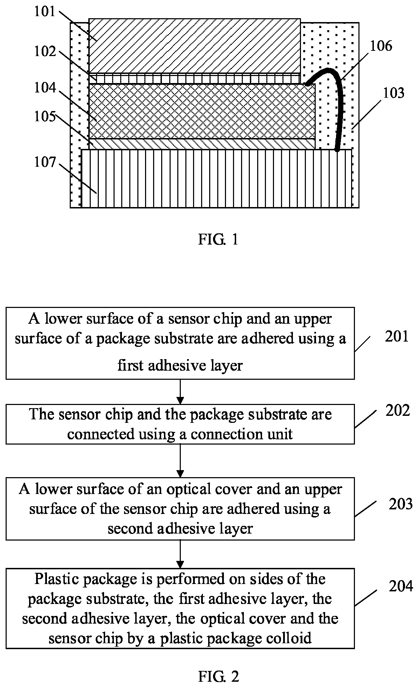

As shown in FIG. 1, in an embodiment of the present disclosure, an optical fingerprint sensor includes an optical cover 101, a plastic package colloid 103, a sensor chip 104, a connection unit 106, and a package substrate 107.

A lower surface of the optical cover 101 and an upper surface of the sensor chip 104 are adhered together by a second adhesive layer 102, a lower surface of the sensor chip 104 and an upper surface of the package substrate 107 are adhered together by a first adhesive layer 105, the sensor chip 104 and the package substrate 107 are connected by the connection unit 106, and plastic package is performed on sides of the package substrate 107, the first adhesive layer 105, the sensor chip 104, the second adhesive layer 102 and the optical cover 101 by the plastic package colloid 103.

It should be noted that the plastic package colloid 103 shall expose an upper surface of the optical cover 101.

The optical cover 101 is light-transmissive. The optical cover can also be used to amplify a transmitted light signal. The optical cover can also be used to protect the sensor chip, and in this case, the optical cover can also be referred to as a protective layer.

The package substrate 107 is used to carry the sensor chip 104 and connect a signal of the sensor chip 104 to the outside. In addition, the package substrate 107 can also provide protective and heat dissipation functions.

The connection unit 106 is used to transmit an electric signal output by the sensor chip 101 to the package substrate 107.

Except for features of a plastic package colloid used in a general packaging, the plastic package colloid 103 may also have a light blocking property, that is, the plastic package colloid 103 is opaque to light.

The sensor chip 104 is used to receive light reflected from a finger of a user and convert the reflected light into an image to identify a fingerprint of the user.

According to the optical fingerprint sensor in the embodiment of the present disclosure, since an optical cover and a sensor chip are adhered together by the second adhesive layer, seamlessly and directly attachment of the optical cover and the sensor chip can be achieved, and a volume of the entire optical fingerprint sensor can be reduced, so that availability of the optical fingerprint sensor in an electronic device can be improved.

In addition, the use of a plastic package colloid to perform the plastic package on the sensor chip, the package substrate and the optical cover can provide a protective effect.

As illustrated in FIG. 1, an upper surface of the optical cover is higher than an upper surface of the plastic package colloid, and a height difference thereof generally cannot exceed 50 µm. Optionally, the upper surface of the optical cover can also be flush with the upper surface of the plastic package colloid.

The first adhesive layer 105 may be an adhesive layer formed by uniformly coating and curing of an organic adhesive (such as an epoxy adhesive), and may also be an adhesive film.

The second adhesive layer 102 may be an organic solid adhesive with a high light transmittance, and the optical cover and the sensor chip may be evenly adhered to the uniform second adhesive layer by process similar to die attaching process. The second adhesive layer, to the greatest extent, does not contain bubbles, voids and the like that affect uniformity.

The second adhesive layer is transmissive, so that the light transmitted through the optical cover can reach the sensor chip.

In general, the second adhesive layer has a good adhesive property as much as possible, which can stably adhere the optical cover to the sensor chip. A thickness of the second adhesive layer is also better not to exceed 50 microns. A tilt of the optical cover with respect to the sensor chip is better not to exceed 50 µm, and a light-transmissive range of the second adhesive layer should cover a visible light waveband as much as possible.

Optionally, the package substrate may be a metal frame, a flexible circuit board, a flexible and rigid printed circuit board, or a printed circuit board used for package.

Optionally, the package substrate may have a light blocking effect, that is, it is opaque to light. The package substrate is opaque to light for example, by filling a via, printing a black solder mask, or the like.

Optionally, the lower surface of the sensor chip is opaque to light. Specifically, the lower surface of the sensor chip may be covered with a light blocking layer, such as a black silica gel layer.

The light blocking layer can be generated by screen printing, printing, spin-coating, electroplating, vacuum plating, or the like. Alternatively, the lower surface of the sensor chip may be grinded, and further, the light blocking layer may be made on the grinded lower surface. Alternatively, colored target material may be accelerated and bombarded to the lower surface of the sensor chip, to form the light blocking layer.

Optionally, the first adhesive layer may have a light blocking effect, that is, it is opaque to light.

Optionally, the lower surface of the sensor chip and the upper surface of the package substrate may be evenly adhered together by the first adhesive layer to avoid light refraction. Specifically, after the sensor chip and the package substrate are adhered together by the first adhesive layer, a tilt of the sensor chip with respect to the package substrate does not exceed 50 µm, so as to avoid affecting the performance of fingerprint detection.

Optionally, the connection unit may include a metal bonding wire, a gold wire or a copper wire, a metal bump, a rewiring line, a flexible circuit lamination connection, or the like.

Optionally, the lower surface of the sensor chip may have a slot that controls a wire loop height, the connection unit passes through the slot, and then is connected to the package substrate.

Optionally, the connection unit can be realized by spin-coating process that controls stability of a wire loop or other processes.

Optionally, the optical cover may be a silicon dioxide layer formed by means of spin-coating, or a glass sheet or a resin sheet produced by means of lamination processing, to avoid the sensor chip from damaging during processing or use.

Optionally, the lower surface of the optical cover may completely cover a pixel area of the sensor chip, in other words, a size of the lower surface of the optical cover may be larger than a size of a pixel layout of the sensor chip, the sensor chip.

Optionally, in the optical fingerprint sensor shown in FIG. 1, a side of the optical cover may have a screw thread. Alternatively, a side of the optical cover may include a lock type structure, so that the side of the optical cover can be attached to the plastic package colloid by a camera lock process or other lock type processes. Thus, adhesion between the optical cover and the sensor chip can be enhanced, furthermore, reliability of an environmental test can be improved.

FIG. 2 is a schematic flow diagram of a packaging method of an optical fingerprint sensor according to an embodiment of the present disclosure. It should be understood that FIG. 2 shows steps or operations of the packaging method, but these steps or operations are merely examples, and an embodiment of the present disclosure can also execute other operations or variations of the respective operations in FIG. 2. In addition, steps in FIG. 2 may be executed in a different order as presented in FIG. 2, and it is possible not to execute all the operations in FIG. 2.

S201. A lower surface of a sensor chip and an upper surface of a package substrate are adhered using a first adhesive layer.

S202. The sensor chip and the package substrate are connected using a connection unit.

S203. A lower surface of an optical cover and an upper surface of the sensor chip are adhered using a second adhesive layer.

S204. Plastic package is performed on sides of the package substrate, the first adhesive layer, the second adhesive layer, the optical cover and the sensor chip by a plastic package colloid.

According to the optical fingerprint sensor packaged by using the packaging method in the embodiment of the present disclosure, since an optical cover and a sensor chip are adhered together by the second adhesive layer, seamlessly and directly attachment of the optical cover and the sensor chip can be achieved, and a volume of the entire optical fingerprint sensor can be reduced, so that availability of the optical fingerprint sensor in an electronic device can be improved.

It should be noted that when a plastic package is performed on the sides of the package substrate, the first adhesive layer, the second adhesive layer, the optical cover and the sensor chip by the plastic package colloid, the plastic package colloid shall expose an upper surface of the optical cover.

The upper surface of the optical cover can be flush with an upper surface of the plastic package colloid, or the upper surface of the optical cover is higher than an upper surface of the plastic package colloid, whereas a height difference of the upper surface of the optical cover and the upper surface of the plastic package colloid is less than or equal to 50 microns.

Optionally, a side of the optical cover may have a screw thread or a lock type structure, so that the side of the optical cover can be attached to the plastic package colloid by camera lock process or other lock type processes. Thus, adhesion between the optical cover and the sensor chip can be enhanced, furthermore, reliability of an environmental test can be improved.

Optionally, the lower surface of the optical cover may completely cover a pixel area of the sensor chip, in other words, a size of the lower surface of the optical cover may be larger than a size of a pixel layout of the sensor chip, so as to reduce an influence on a yield of a broken pixel due to the overflow of an adhesive to the optical cover in the process of the plastic package.

According to the packaging method of the embodiment of the present disclosure, the optical fingerprint sensor shown in FIG. 1 can be obtained, that is, each technical feature in the optical fingerprint sensor shown in FIG. 1 is also applicable to the packaging method shown in FIG. 2, which is not repeatedly described herein for brevity.

In S201, the package substrate and the sensor chip can be adhered together using the first adhesive layer by a common die attaching process. Flatness between the package substrate and the sensor chip should be ensured as much as possible, to avoid affecting performance of the optical fingerprint sensor.

Specifically, the first adhesive layer can control a tilt between the package substrate and the sensor chip not exceeding 50 µm.

In S203, the optical cover can be adhered to the sensor chip using the second adhesive layer by process similar to the die attaching process. Flatness and uniformity of the second adhesive layer can be ensured as much as possible. For example, the flatness and the uniformity of the second adhesive layer can be achieved by controlling a thickness, a tilt, a filler, a hole, and the like of the second adhesive layer.

In S202, the sensor chip and the package substrate being connected by the connection unit can be achieved by a wafer slot that controls a wire loop height or spin-coating process that controls stability of a wire loop on the lower surface of the sensor chip, or other processes.

Optionally, in an embodiment of the present disclosure, the lower surface of the sensor chip may be grinded, and selectively, a light blocking layer may be made on the grinded lower surface, such as a black silica gel layer or the like; alternatively, the colored target material may be accelerated and bombarded to the lower surface of the sensor chip, to form the light blocking layer; and alternatively, the light blocking layer can be generated on the lower surface of the sensor chip by screen printing, printing, spin-coating, electroplating, vacuum plating, or the like.

Optionally, in an embodiment of the present disclosure, a silicon dioxide layer, that is, the optical cover, can be formed by means of spin-coating, or the optical cover, such as a glass sheet, a resin sheet or the like is produced by means of lamination processing, to avoid the sensor chip from damaging during processing or use.

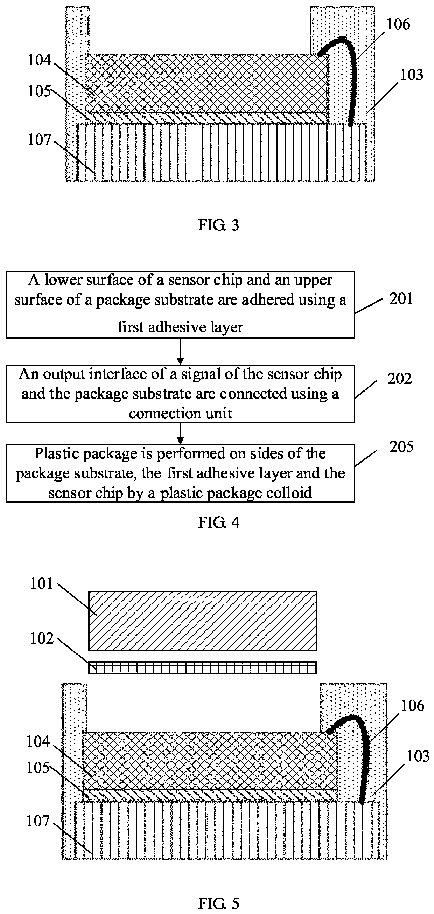

FIG. 3 is an exemplary structural diagram of an optical fingerprint sensor according to another embodiment of the present disclosure. An optical fingerprint sensor shown in FIG. 3 includes a plastic package colloid 103, a sensor chip 104, a connection unit 106, and a package substrate 107.

A lower surface of the sensor chip 104 is adhered to an upper surface of the package substrate 107 by a first adhesive layer 105, the sensor chip 104 is connected to the package substrate 107 by the connection unit 106, and plastic package is performed on sides of the package substrate 107, the first adhesive layer 105 and the sensor chip 104 by a plastic package colloid 103. It should be noted that the plastic package colloid shall expose a pixel area of the sensor chip 104.

According to the optical fingerprint sensor in the embodiment of the present disclosure, during a subsequent package process, the optical cover and the sensor chip can be seamlessly and directly attached, and a volume of the optical fingerprint sensor after being attached to the optical cover can be reduced, so that availability of the optical fingerprint sensor in an electronic device can be improved.

In addition, the plastic package is performed on the sides of the package substrate 107, the first adhesive layer 105 and the sensor chip 104 by the plastic package colloid 103, which can protect the sensor chip.

Reference signs in FIG. 3 have the same or similar meanings as those in FIG. 1, which are not described repeatedly herein for brevity.

It should be noted that an upper surface of the plastic package colloid should be higher than an upper surface of the sensor chip so that after the upper surface of the sensor chip is attached to the optical cover, a surface of the optical cover can be flush with a surface of the plastic package colloid, or so that an upper surface of the optical cover is higher than the upper surface of the plastic package colloid, and a height difference of the upper surface of the optical cover and the upper surface of the plastic package colloid is less than or equal to 50 microns.

FIG. 4 is a schematic flow diagram of a packaging method of an optical fingerprint sensor according to an embodiment of the present disclosure. It should be understood that FIG. 4 shows steps or operations of the packaging method, but these steps or operations are merely examples, and an embodiment of the present disclosure can also execute other operations or variations of the respective operations in FIG 4. In addition, steps in FIG. 4 may be executed in a different order as presented in FIG. 4, and it is possible not to execute all the operations in FIG. 4.

S201. A lower surface of a sensor chip and an upper surface of a package substrate are adhered using a first adhesive layer.

S202. An output interface of a signal of the sensor chip and the package substrate are connected using a connection unit.

S205. Plastic package is performed on sides of the package substrate, the first adhesive layer and the sensor chip by a plastic package colloid. It should be noted that the plastic package colloid shall expose a pixel area of the sensor chip.

According to the optical fingerprint sensor packaged by using the packaging method in the embodiment of the present disclosure, an optical cover and the sensor chip can be seamlessly and directly attached, and a volume of the optical fingerprint sensor after being attached to the optical cover can be reduced, so that availability of the optical fingerprint sensor in an electronic device can be improved.

An upper surface of the plastic package colloid should be higher than an upper surface of the sensor chip.

According to the packaging method of the embodiment of the present disclosure, the optical fingerprint sensor shown in FIG. 3 can be obtained. In the packaging method of the embodiment of the present disclosure, the steps that have the same reference signs as those in the packaging method shown in FIG. 2 indicate the same or similar meanings, which are not described repeatedly herein for brevity.

A packaging method is further provided in the present disclosure, and as shown in FIG. 5, a lower surface of an optical cover 101 is adhered to an upper surface of a sensor chip 104 by a second adhesive layer 102, to cover a pixel area. Reference signs in FIG. 5 have the same meanings as those in FIG. 3, which are not described repeatedly herein.

A height difference of an upper surface of the optical cover and an upper surface of a plastic package colloid may be greater than or equal to 0 and less than or equal to 50 microns.

## Claims

1. An optical fingerprint sensor, wherein the optical fingerprint sensor comprises a package substrate, a sensor chip, an optical cover, a plastic package colloid and a connection unit, and the optical cover is light-transmissive;
a lower surface of the sensor chip is adhered to an upper surface of the package substrate by a first adhesive layer, and a lower surface of the optical cover is adhered to an upper surface of the sensor chip by a second adhesive layer, the sensor ship is connected to the package substrate by the connection unit, plastic package is performed on sides of the package substrate, the first adhesive layer, the sensor chip, the second adhesive layer and the optical cover by the plastic package colloid, and the second adhesive layer is light-transmissive.

2. The optical fingerprint sensor according to claim 1, wherein the plastic package colloid is opaque to light.

3. The optical fingerprint sensor according to claim 1, wherein a height difference of an upper surface of the optical cover and an upper surface of the plastic package colloid is greater than or equal to 0 and less than or equal to 50 microns.

4. The optical fingerprint sensor according to any one of claims 1 to 3, wherein a side of the optical cover has a screw thread or a lock type structure.

5. The optical fingerprint sensor according to any one of claims 1 to 3, wherein the lower surface of the optical cover completely covers a pixel area of the sensor chip.

6. The optical fingerprint sensor according to any one of claims 1 to 3, wherein the optical cover is a silicon dioxide layer formed by means of spin-coating, or a glass sheet or a resin sheet produced by means of lamination processing.

7. The optical fingerprint sensor according to any one of claims 1 to 3, wherein at least one of the package substrate, the first adhesive layer, and the lower surface of the sensor chip is opaque to light.

8. A packaging method of an optical fingerprint sensor, wherein the optical fingerprint sensor comprises a package substrate, a sensor chip, an optical cover, a plastic package colloid and a connection unit, the optical cover is light-transmissive, and the packaging method comprises:
adhering a lower surface of the sensor chip and an upper surface of the package substrate using a first adhesive layer;
connecting the sensor chip and the package substrate using the connection unit;
adhering a lower surface of the optical cover and an upper surface of the sensor chip using a second adhesive layer, wherein the second adhesive layer is light-transmissive; and
performing plastic package on sides of the package substrate, the first adhesive layer, the sensor chip, the second adhesive layer and the optical cover using the plastic package colloid.

9. The packaging method according to claim 8, wherein the plastic package colloid is opaque to light.

10. The packaging method according to claim 8, wherein a height difference of an upper surface of the optical cover and an upper surface of the plastic package colloid is greater than or equal to 0 and less than or equal to 50 microns.

11. The packaging method according to any one of claims 8 to 10, wherein a side of the optical cover has a screw thread or a lock type structure.

12. The packaging method according to any one of claims 8 to 10, wherein the lower surface of the optical cover completely covers a pixel area of the sensor chip.

13. The packaging method according to any one of claims 8 to 10, wherein the optical cover is a silicon dioxide layer formed by means of spin-coating, or a glass sheet or a resin sheet produced by means of lamination processing.

14. The packaging method according to any one of claims 8 to 10, wherein at least one of the package substrate, the first adhesive layer, and the lower surface of the sensor chip is opaque to light.

15. An optical fingerprint sensor, wherein the optical fingerprint sensor comprises a package substrate, a sensor chip, a plastic package colloid and a connection unit, and the optical cover is light-transmissive;
a lower surface of the sensor chip is adhered to an upper surface of the package substrate by a first adhesive layer, the sensor ship is connected to the package substrate by the connection unit, plastic package is performed on sides of the package substrate, the first adhesive layer and the sensor chip by the plastic package colloid, and an upper surface of the plastic package colloid is higher than an upper surface of the sensor chip.

16. The optical fingerprint sensor according to claim 15, wherein the plastic package colloid is opaque to light.

17. The optical fingerprint sensor according to any one of claim 15 or 16, wherein at least one of the package substrate, the first adhesive layer, and the lower surface of the sensor chip is opaque to light.

18. A packaging method of an optical fingerprint sensor, wherein the optical fingerprint sensor comprises a package substrate, a sensor chip, a plastic package colloid and a connection unit, and the packaging method comprises:
adhering a lower surface of the sensor chip and an upper surface of the package substrate using a first adhesive layer;
connecting the sensor chip and the package substrate using the connection unit; and
performing plastic package on sides of the package substrate, the first adhesive layer and the sensor chip using the plastic package colloid, wherein an upper surface of the plastic package colloid is higher than an upper surface of the sensor chip.

19. The packaging method according to claim 18, wherein the plastic package colloid is opaque to light.

20. The packaging method according to claim 18, wherein at least one of the package substrate, the first adhesive layer, and the lower surface of the sensor chip is opaque to light.

21. A packaging method of an optical fingerprint sensor, wherein the optical fingerprint sensor is the optical fingerprint sensor according to any one of claims 15 to 17, and the packaging method comprises:
adhering a lower surface of an optical cover to the upper surface of the sensor chip of the optical fingerprint sensor using a second adhesive layer.

22. The packaging method according to claim 21, wherein a height difference of an upper surface of the optical cover and the upper surface of the plastic package colloid of the optical fingerprint sensor is greater than or equal to 0 and less than or equal to 50 microns.
